# EUROPEAN PATENT APPLICATION

(11) **EP 4 714 899 A1**
(43) Date of publication of application: **25.03.2026**
(21) Application number: 24806718.3
(22) Date of filing: 03.05.2024
(51) Int. Cl.: B81C 1/00

(54) **METHOD FOR PRODUCING PLANAR MICROPARTICLES AND PLANAR MICROPARTICLES**

(30) Priority: 17.05.2023 ES 202330381
(71) Applicant: Consejo Superior De Investigaciones Científicas (CSIC), 28006 Madrid (ES)
(72) Inventor: PLAZA PLAZA, José Antonio, 08193 Bellaterra, Barcelona (ES); AGUSIL ANTONOFF, Juan Pablo, 08193 Bellaterra, Barcelona (ES)
(74) Representative: Pons IP
(86) International application number: PCT/ES2024/070270
(87) International publication number: WO 2024/236207

(57) **Abstract**

The invention relates to a method for producing elongate planar microparticles (1) that increases the production yield of these microparticles (1) and comprises the steps of: preparing a structuring layer of a microparticle (1) starting material on a substrate (2); defining the shape of the microparticles (1) in the structuring layer by using a photolithography technique and an engraving technique that defines the thickness of the microparticles (1), where the shape of the microparticles (1) is such that it comprises an elongate central body (3) with longer sides and shorter sides, with at least two side wings (4) extending from the longer sides; and forming one or more feet (5) with a circular section in an upper portion of the substrate (2) that is under the structuring layer.

## Description

### OBJECT OF THE INVENTION

The object of the present invention is a method for producing elongate, essentially rectangular planar microparticles attached to a substrate by means of one or more feet, which increases the production yield of said microparticles.

### BACKGROUND OF THE INVENTION

In the field of engineering and material science, a particle is understood to be any entity with a micrometric or nanometric scale, having a mass and which may be obtained naturally or artificially by means of physical and chemical methods. At present, the different existing techniques for obtaining micro- and nanoparticles may be classified into two large groups, based on whether they are produced directly in an individual manner or whether they are obtained in the form of an ordered array.

All the techniques encompassed in the first of the groups listed above (individual particle production) are based on two different types of approaches, called top-down approach and bottom-up approach.

The first is based on obtaining particulate material from a bulk or block of material or larger structures, through progressive reductions in size.

The bottom-up approach, on the other hand, consists of supramolecular chemical synthesis, which uses the chemical information contained in the different individual components (atoms or molecules) to get them to spontaneously group together into larger complex particles by means of self-assembly processes.

In recent years there has been increased scientific interest in the development of new polymer-based materials and compounds. By using chemical synthesis techniques, techniques as diverse as flow-focusing, pulverisation or microemulsion have been developed which, combined with microfluidics, are also being used for the production of both simple and compound particles.

What is common to all of these self-assembly techniques is the direct obtaining of large quantities of identical particles, made individually and at a low cost. The main drawback of these particle production methods is that strictly chemical methods must be applied for their functionalisation, whereby either a total and single (identical) functionalisation may be obtained for all of them, or a combination of two or more functionalisations by using chemical substances, as long as these do not affect one another. This is a difficult and highly complex process due to the multiple incompatibilities that this entails (neither versatility nor discretisation).

The particles obtained by the methods described above are usually used in the field of pharmaceuticals and biomedicine as drug delivery systems, although they are also widely used, in the case of magnetic particles, as magnetic separation bioprocesses by magnetophoresis and electromagnetophoresis processes, as well as for research into new materials and compounds.

On the other hand, there is the set of techniques for producing ordered arrays of molecules or nanoparticles, said techniques being based on micro- and nanoelectronics manufacturing processes. These techniques, both those based on conventional photolithography processes and those based on processes known as soft-lithography, such as micromoulding, microcontact printing (MCP), etc., also allow for the simultaneous production of thousands of functional units (the concept of batch processing), in a controlled and low-cost manner, but with high adaptability for use on particles made of materials as diverse as metals and polymers, including a large number of biomaterials, and the possibility of combinations between them.

These processes give the designed functional units of molecules or nanoparticles great versatility both in terms of shape and dimensions and make it possible to simultaneously obtain different types of functionalisations on the particles. Although in some cases the production process of functional units of this type is more complex than those mentioned above, these techniques make it possible to obtain particles with multiple surfaces, opening up the range to a wide variety of possible applications.

Given their ordered and controlled location on the surface of the substrate where they are produced, these molecules or nanoparticles make it possible to apply different types of functionalisation on a single particle, in a localised manner within the same.

At present, the existing techniques for separating particles obtained by lithographic processes from the production substrate, a concept known as particle release or individualisation, require the use of methods based on the use of chemical agents that may be aggressive for the multiplexed molecules or nanoparticles on their surface, where a sacrificial layer, located between the particle and the substrate, is etched with chemicals.

Multiplexed chips (understood as those chips that bring together, in a single substrate-particle, several types of channels that can provide and receive different information by means of each one of the functionalisations printed on their surface) made up of an ordered array of functional units and with dimensions on the order of centimetres, such as DNA chips, have been widely used in fields such as medicine and biology to identify, quantify and determine the functioning of certain molecules.

For cases in which small volumes of samples must be analysed, the current technological solution is to produce particle suspensions in which each element is comprised by a subpopulation of particles that differ from the other groups in that they have different anisotropic attributes (shape, dimensions, colour, etc.). The lack of multiplexing on a single particle of those containing these suspensions, a characteristic that multiplexed chips do offer, is a significant limitation when it comes to analysing small volumes (for example, the inside of a cell).

In this regard, the state of the art discloses document PCT/ES2015/070439 which describes a method for obtaining an array of planar microparticles with surface molecular multiplexing. The invention further proposes an array of microparticles, the surface thereof being printed with all of the molecular components required to provide same with functionality. This product can be produced thanks to the design of a process in which the different molecular elements are multiplexed on the surface of each particle while they are supported on a substrate by means of a foot engraved below same. These microparticles can be released mechanically from the support where they are produced by means of a controlled mechanical rupture method, which is a chemically non-aggressive method and therefore does not affect the molecules previously printed on the surface thereof.

Nevertheless, in this invention the microparticles have very limited shapes, which can only be square or circular, so that the anchor foot created in its production has a round cross-section.

If the microparticles were elongate, an elongate foot would be obtained, i.e., with an elliptical cross-section. When trying to release these microparticles with the elongate foot, the mechanical stresses of the material when the foot is subjected to a lateral force would be transmitted to the microparticles and would break both said microparticles and the foot.

### DESCRIPTION OF THE INVENTION

The present invention relates to a method for producing elongate planar microparticles that significantly increases the production yield of particles of this type. Particularly, the method relates to producing an ordered array of planar microparticles with molecular or nanoparticle multiplexing on their surface, having variable geometry and dimensions depending on their final application, obtained from techniques for producing microelectronics.

The functionalisation of their surface can be carried out in a controlled and ordered manner with a wide variety of molecules or nanoparticles simultaneously. The microparticles are moulded and prepared on a substrate and are held on the same by one or more securing feet that are engraved below them, and they can be separated (released) by a controlled mechanical rupture method and in the absence of chemical release techniques, due to the formation of this new structural element called the "foot" of the microparticle in the array.

This foot, which is similar to a column or pillar, acts as an element for securing said microparticles that make up the array to the substrate during the processes of molecular moulding and multiplexing on their surface and in turn acts as an element that concentrates mechanical stress, making it the weakest point in the entire assembly. This makes it possible, in the event that the microparticles are to be released, to apply directed mechanical stress in order to break the foot in a controlled manner, without damaging the microparticles or the multiplexed molecules or nanoparticles on their surface, since no chemical releasing substances are used which might affect the structure or function of said prints.

In other words, in addition to being able to obtain an array of surface-functionalised microparticles, as opposed to other known methods, it is possible to individualise the microparticles in the array by means of a chemically non-aggressive method, i.e., one which does not require the use of chemical agents that might damage the integrity of the microparticle or affect the molecular or nanoparticle functionalisation previously carried out.

Once released, said microparticles, as well as the array, are able to act as sensors or actuators of different chemical and biological activities produced in the medium where they are found.

In particular, the method comprises a first step of preparing a structuring layer of a microparticle starting material on a substrate that serves as a support.

Next, the microparticles in the structuring layer are shaped by a photolithography technique that defines the shape, and an engraving technique that defines the thickness of the microparticles. The shape of the microparticles is defined in such a way that they comprise an elongate, essentially rectangular body, with longer sides and shorter sides. Furthermore, at least two side wings extend from the longer sides.

The next step consists of forming one or more feet with a round section in the upper portion of the substrate that is under the structuring layer, specifically in a region from which the side wings extend, to support each microparticle by using engraving techniques.

An optional subsequent step consists of chemically functionalising the surface of the microparticles that are supported on the substrate with the feet by means of one or more molecular components or nanoparticles.

Lastly, the method may comprise an additional step of breaking the feet that support the microparticles by applying mechanical breaking loads in order to separate said microparticles from the substrate and individualise them.

Another object of the invention relates to an array of planar microparticles obtainable by using the above method.

If the microparticles did not comprise the side wings, i.e., they had a completely rectangular shape, the foot obtained during production would also be elongate, i.e., the cross-section of this foot would be elliptical. If an attempt is made to release the microparticles with the elongate foot, the mechanical stresses of the material when the foot is subjected to a lateral force are transmitted to the microparticle and break the foot and also the microparticle.

For this reason, the microparticles comprise side wings that force the generation of one or more feet with a round cross-section during their production, making them more fragile in their central area and thus preventing the mechanical stresses due to the lateral force from being transmitted to the microparticles when the foot/feet are broken to release them. This increases the release of intact microparticles.

This method is used to release microparticles that are elongate or have a more complex without damage. These feet are also robust enough to withstand a vertical force on the microparticle so that they can be functionalised with contact printing techniques prior to release.

### DESCRIPTION OF THE DRAWINGS

To complement the description that is being made and for the purpose of helping to better understand the features of the invention, according to a preferred practical exemplary embodiment thereof, a set of figures is attached as an integral part of said description wherein the following has been depicted in an illustrative and non-limiting manner:
Figure 1 shows a section of the structuring layer of the microparticle on the substrate.
Figure 2 shows a section of the structuring layer of the microparticle trimmed by photolithography.
Figure 3 shows a section of the microparticle on the engraved foot, in an embodiment with a single foot.
Figure 4 shows a section of the microparticle on the engraved foot, in an embodiment with two feet.
Figure 5 shows a section of the microparticle with a monolayer, with a single foot (top) and two feet (bottom).
Figure 6 shows a section of the microparticle with prints, with a single foot (top) and two feet (bottom).
Figure 7 shows a section of the microparticle released from the substrate with the breakage of the foot, with a single foot (top) and two feet (bottom).
Figure 8 shows a first embodiment of the microparticle with two side wings.
Figure 9 shows a second embodiment of the microparticle with four side wings.
Figure 10 shows a real microscopic photograph of the microparticles, those in the left column being separated from the substrate due to the breakage of the foot.

### PREFERRED EMBODIMENT OF THE INVENTION

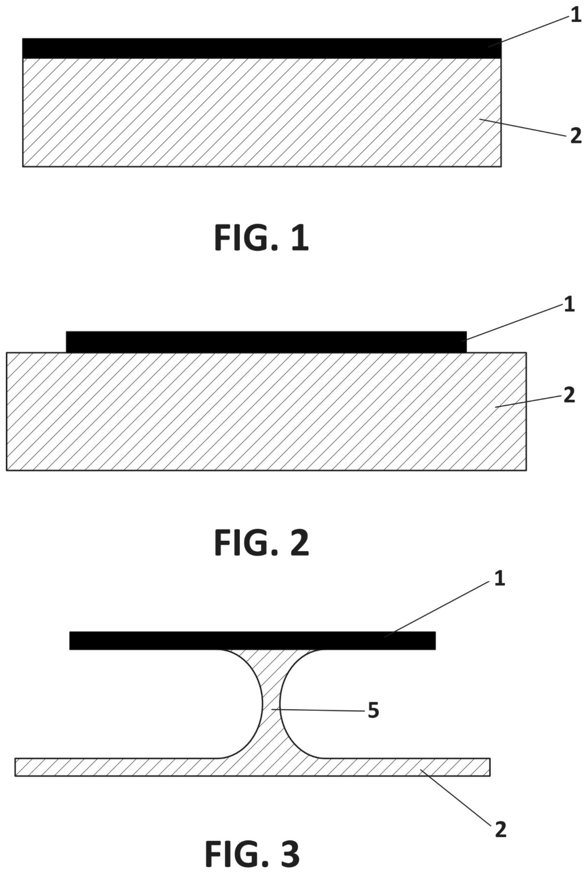

A preferred embodiment of the method for producing planar microparticles (1), object of the present invention, is described below with the help of figures 1 to 10.

Specifically, the method comprises a first step, shown in figure 1, of preparing a structuring layer of a microparticle (1) starting material on a substrate (2) that serves as a support. In an aspect of the invention, the structuring layer is made of silicon oxide. In an aspect of the invention, the substrate (2) is made of silicon.

Next, as depicted in figure 2, the microparticles (1) in the structuring layer are shaped by a photolithography technique that shapes the geometry and lateral dimensions, and an engraving technique that defines the thickness of the microparticles (1).

The shape of the microparticles (1) is defined in such a way that they have an elongate, essentially rectangular central body (3), with longer sides and shorter sides. Furthermore, at least two side wings (4) extend from the longer sides.

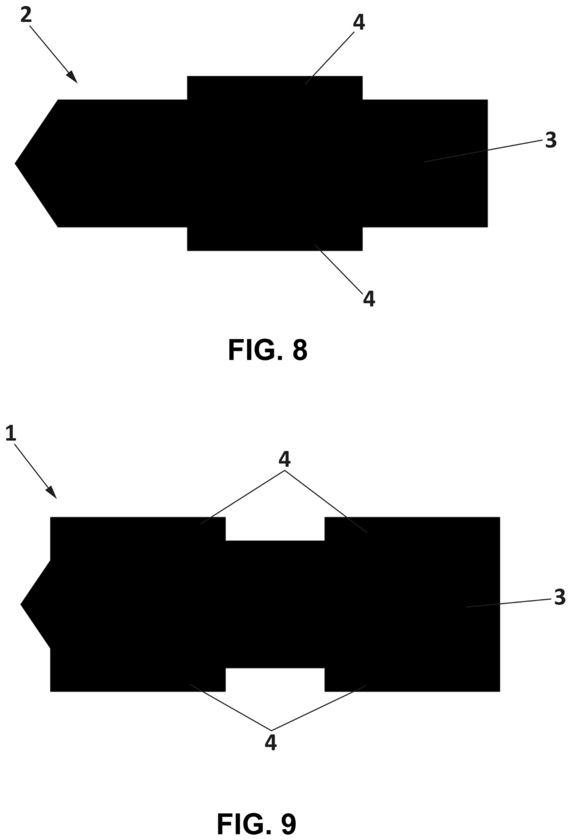

In a first embodiment of the invention, described in figure 8, the microparticles (1) comprise a rectangular central body (3) from which two side wings (4) extend from its longer sides.

In a second embodiment of the invention, described in figure 9, the microparticles (1) comprise a rectangular central body (3) from which four side wings (4) extend from its longer sides, two on each longer side and spaced a certain distance apart.

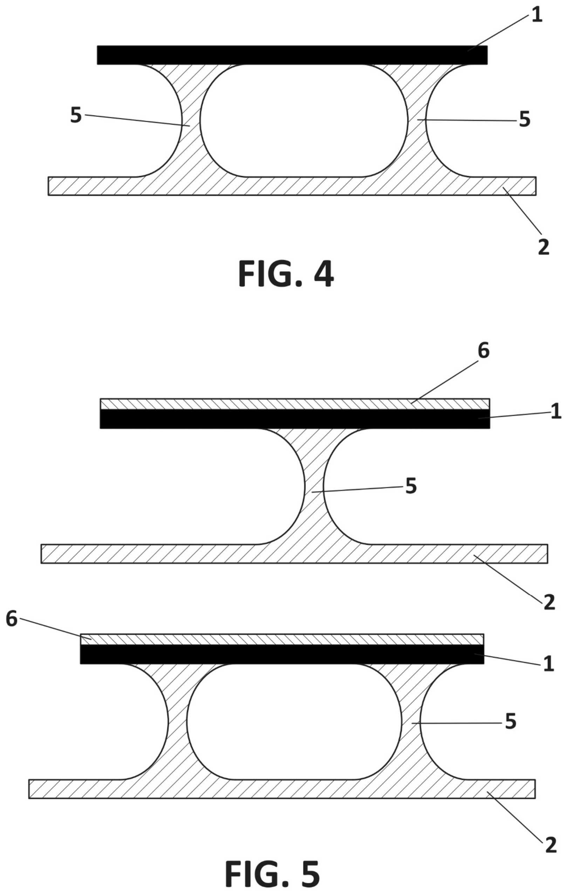

The next step, reflected in figures 3 and 4, consists of forming one or more feet (5) with a round section in the upper portion of the substrate (2) that is under the structuring layer, specifically in a region of the central body (3) from which the side wings (4) extend, to support each microparticle (1) by using engraving techniques.

In the case of figure 3, the microparticle (1) comprises two side wings (4) like the microparticle (1) in figure 8, and therefore comprises a single foot (5). In the case of figure 4, the microparticle (1) comprises four side wings (4) like the microparticle (1) in figure 9, and therefore comprises two feet (5).

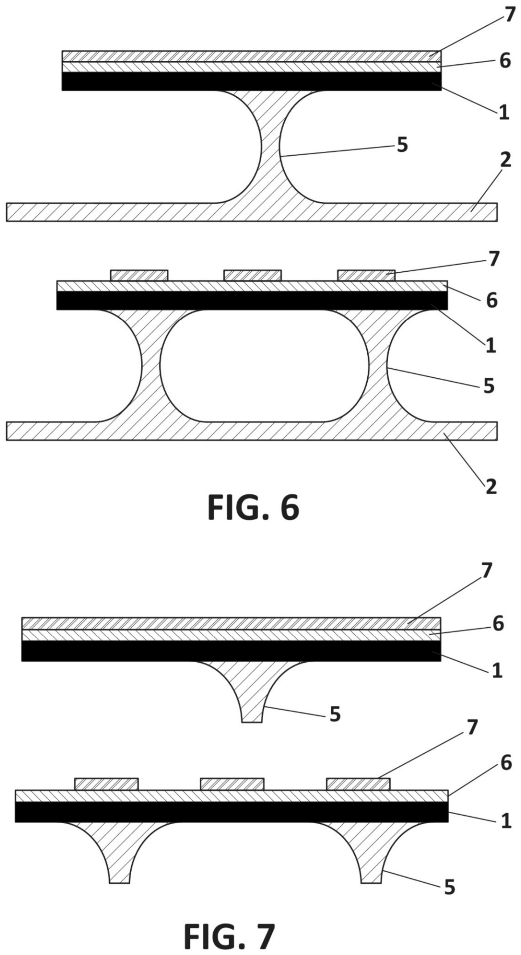

A subsequent step consists of chemically functionalising the surface of the microparticles (1) that are supported on the substrate (2) with the feet (5) by means of one or more molecular components or nanoparticles, as reflected in figures 5 and 6.

In figure 5, a heterobifunctional silane is used to form a monolayer (6) and provide the surface with reactive sites. The feet (5) are designed to withstand the printing pressure of the monolayers (6). Furthermore, in the top image of figure 6, a homogeneous print (7) is made on the surface of the monolayer (6). In the bottom image of figure 6, a print (7) is made in the form of a pattern on the monolayer (6).

The silanes in the monolayer (6) may be 3-glycidoxypropyltrimethoxysilane (Epoxy-silane) or (3-Aminopropyl)triethoxysilane (Amino-silane).

If Epoxy-silane is used in the monolayer (6), the print (7) may be selected from proteins, antibodies, oligonucleotides modified with an amino (-NH₂) or thiol (-SH) functional group, nanoparticles as quantum dots functionalised with an amino (-NH₂) group. On the other hand, if the monolayer (6) is made of Amino-silane, the imprint (7) may be selected from fluorophores with an N-Hydroxysuccinimide or N-succinimidyl ester functional group.

Lastly, the method may comprise an additional step of breaking the feet (5) that support the microparticles (1) by applying mechanical breaking loads in order to separate said microparticles (1) from the substrate (2) and individualise them, as in figure 7.

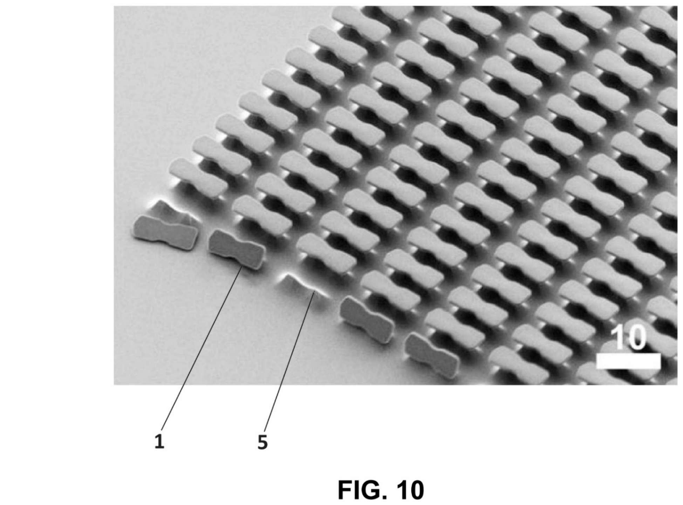

Figure 10 shows a microscopic image of an array of microparticles (1) in which those in the left column have been separated from the substrate (2) due to the breakage of the feet (5). In this case, each of the microparticles (1) comprises two feet (5).

## Claims

1. A method for producing planar microparticles (1), comprising the steps of:
- preparing a structuring layer of a microparticle (1) starting material on a substrate (2) that serves as a support,
- defining the microparticles (1) in the structuring layer by using a photolithography technique the defines the shape and an engraving technique that defines the thickness of the microparticles (1),
the method being **characterised in that** in the step of defining the particles (1), the microparticles (1) are defined in such a way that they comprise an elongate central body (3), with longer sides and shorter sides, with at least two side wings (4) extending from the longer sides, and the method further comprising a step of:
- forming, by using engraving techniques, one or more feet (5) with a circular cross-section in an upper portion of the substrate (2) located under a region of the central body (3) from which the side wings (4) extend.

2. The method of claim 1, comprising an additional step of chemically functionalising the surface of the microparticles (1) supported on the substrate (2) with the feet (5), by means of one or more molecular components or nanoparticles.

3. The method of claim 2, comprising an additional step of breaking the feet (5) that support the microparticles (1) by applying mechanical breaking loads in order to separate said microparticles (1) from the substrate (2) and individualise them.

4. The method of claim 1, wherein the structuring layer is made of silicon oxide.

5. The method of claim 1, wherein the substrate (2) is made of silicon.

6. The method of claim 1, wherein the microparticles (1) comprise an elongate central body (3), with longer sides and shorter sides, from which two side wings (4) extend from its longer sides, and wherein the microparticles (1) are attached to the substrate (2) with a single foot (5).

7. The method of claim 1, wherein the microparticles (1) comprise an elongate central body (3), with longer sides and shorter sides, from which four side wings (4) extend from its longer sides, two on each longer side and spaced a certain distance apart, and the microparticles (1) being attached to the substrate (2) with two feet (5).

8. The method of claim 2, wherein the step of chemically functionalising the surface of the microparticles (1) comprises the deposition of a monolayer (6) of a heterobifunctional silane.

9. The method of claim 8, wherein the heterobifunctional silane of the monolayer (6) is selected from 3-glycidoxypropyltrimethoxysilane (Epoxy-silane) and (3-Aminopropyl)triethoxysilane (Amino-silane).

10. The method of claim 9, comprising an additional step of making a homogeneous print (7) on the surface of the monolayer (6), wherein the print (7):
- if the monolayer (6) is Epoxy-silane, is selected from proteins, antibodies, oligonucleotides having an amino (-NH₂) or thiol (-SH) functional group and nanoparticles of quantum dots functionalised with an amino (-NH₂) group,
- if the monolayer (6) is Amino-silane, is selected from fluorophores with an N-Hydroxysuccinimide and N-succinimidyl ester functional group.

11. An array of planar microparticles (1) with surface molecular multiplexing obtainable by using the method described in one of claims 1 to 10.
